# EUROPEAN PATENT APPLICATION

(11) **EP 3 620 551 A1**
(43) Date of publication of application: **11.03.2020**
(21) Application number: 19195844.6
(22) Date of filing: 06.09.2019
(51) Int. Cl.: C23C 16/52, C30B 25/16, H01L 21/67

(54) **SYSTEM AND METHOD FOR METROLOGY USING MULTIPLE MEASUREMENT TECHNIQUES**

(30) Priority: 06.09.2018 US 201816123799
(71) Applicant: Veeco Instruments, Inc., Plainview, NY 11803 (US)
(72) Inventor: KWON, Daewon, Plainview, New York 11803 (US)
(74) Representative: Hamer, Thomas Daniel

(57) **Abstract**

Systems and methods for detecting complementary sets of data during a chemical vapor deposition process are disclosed herein. The systems and methods reduce use of limited window space in a chemical vapor deposition reactor, while obtaining useful data for a variety of phases in the epitaxial growth of a structure therein.

## Description

### TECHNICAL FIELD

The present disclosure is directed generally to optical sensors and more specifically to optical sensors for the sensing of wafer topology and temperature in a chemical vapor deposition system.

### BACKGROUND

Chemical vapor deposition (CVD) is a process that can be used to grow desired objects epitaxially. Examples of current product lines of manufacturing equipment that can be used in CVD processes include the TurboDisc®, MaxBright®, EPIK®, and PROPEL® family of MOCVD systems, manufactured by Veeco Instruments Inc. of Plainview, New York.

A number of process parameters are controlled, such as temperature, pressure and gas flow rate, to achieve a desired crystal growth. Different layers are grown using varying materials and process parameters. For example, devices formed from compound semiconductors such as III-V semiconductors typically are formed by growing successive layers of the compound semiconductor using metal organic chemical vapor deposition (MOCVD). In this process, the wafers are exposed to a combination of gases, typically including a metal organic compound as a source of a group III metal, and also including a source of a group V element which flow over the surface of the wafer while the wafer is maintained at an elevated temperature. Generally, the metal organic compound and group V source are combined with a carrier gas which does not participate appreciably in the reaction as, for example, nitrogen. Some examples of a III-V semiconductor are gallium nitride (GaN), which can be formed by reaction of an organo-gallium compound and ammonia; aluminum nitride (AlN), which can be formed by the reaction of aluminum and nitrogen; and aluminum gallium nitride (AlGa₁₋ₓNₓ, where 0 ≤ x ≤ 1), which can be formed by the reaction of aluminum, gallium, and nitrogen. These materials form a semiconductor layer on a wafer made of a suitable substrate having a suitable crystal lattice spacing, as for example, a sapphire wafer. Precursor and carrier gasese containing gallium, aluminum, and nitrogen, for example, can be introduced by a gas injector (also called a showerhead) which is configured to distribute the gases as evenly as possible across the growth surface of the substrate. Other semiconductor layers, such as SiN, TiN, InGaN, GaAs and the like, which are formed from Group II, Group IV, Group V, and Group VI elements, can be formed, and analyzed within the current system and method. Semiconductor layers formed from the foregoing can be undoped, p-doped (with, for example, boron, aluminum, nitrogen, gallium, magnesium, and indium), or n-doped (with, for example, phosphorous, arsenic, and carbon).

The wafer is usually maintained at a temperature on the order of 500-1200°C during deposition of precursor gases and related compounds. The precursor gases, however, are introduced to the chamber at a much lower temperature, typically 200°C or lower. Thus, as the precursor gases approach the wafer, their temperature increases substantially. Depending on the precursor gases used in deposition of the particular wafer under construction, pyrolyzation of the precursor gases can occur at an intermediate temperature between that of the input gases and the wafer. This pyrolyzation facilitates the interaction of the precursor gases and growth of the crystal structure. This crystal structure grows, epitaxially, until a desired thickness is reached.

In a MOCVD process chamber, semiconductor wafers on which layers of thin film are to be grown are placed on rapidly-rotating carousels, referred to as wafer carriers, to provide a uniform exposure of their surfaces to the atmosphere within the reactor chamber for the deposition of the semiconductor materials. Rotation speed is often on the order of 1,000 RPM. The wafer carriers are typically machined out of a highly thermally conductive material such as graphite, and are often coated with a protective layer of a material such as silicon carbide. Each wafer carrier has a set of circular indentations, or pockets, in its top surface in which individual wafers are placed.

In growing various epitaxial or semiconductor layers on the wafer, the precursor and carrier gas flows are generally downward (that is, perpendicular) to the surface of a wafer carrier along an increasing temperature gradient until it reaches pyrolyzation temperatures, then impinges upon the wafer surface(s) that are being grown. To maximize device yield, the thickness of epitaxial layers must be as uniform as possible across the entire area of the wafer. In addition the thickness must be repeatable across runs and systems. Conventionally, this is achieved by examining the results of a previous run and using prior experimental data (sensitivity curves) to adjust gas flows. From this data, an operator can attempt to improve the uniformity or achieve target thickness in the next run. This process is repeated until the uniformity and target thickness is judged to be "good enough" or as good as possible, at which point the recipe is "locked in" and future uniformity variation depends on the repeatability of the system. In other types of MOCVD systems, the precursor and carrier gas flow can also be parallel to the surface of the wafer carrier as well as having one or more precursor and carrier gases flowing vertically downward (perpendicular) to the surface of the wafer carrier while having other precursor and carrier gases flow horizontally across (parallel) to the surface of the wafer carrier.

In order to control the absolute thickness of the epitaxial layer grown on the wafer, the concentration of precursor gas at the surface, as well as the temperature at the surface, can be controlled. The radial uniformity of deposition across the radius of the wafer carrier can be controlled by independently modulating the precursor and dilution flows at the radially inner or outer portions of the reactor, such as by operating various injectors at different rates or precursor gas compositions. Independent control of the concentration of precursor dilution flows can be achieved using precursor or dilution flow control out of a diametrically situated flow inlet in the gas injector (typically aligned with the viewport of the system and called "viewport flow" henceforth). Modulating flow from a diametrical flow inlet in a rotating system can produce a larger response in the center than outer radii. For example, using such a flow control technique in a single-wafer system, the radially inner portions of a layer growing on the wafer could have a different layer thickness than the radially outer portions of the layer on the wafer. Likewise, in batch systems, the radially inner rings of pockets could grow layers having different layer thicknesses than those layers grown in the outer pockets.

The extent of uniformity improvement of layer thicknesses on a wafer based on changes to the flow rates or compositions of the gases is limited in a batch reactor with multiple wafers. In order to make any corrections, it is necessary to collect useful data on the thickness of each layer that has been grown. Conventionally, this is accomplished by removing the wafer from the reactor chamber and measure layer thicknesses by using film thickness measurement techniques such as spectroscopic reflectometry and ellipsometry. However, resolving individual thin layer thickness is extremely difficult due to technical limitation. Often times, total thickness of all layers is the only reliable information that ex situ measurements can provide. In situ spectroscopic reflectometry that uses white light source provides individual layer thickness because it measures the thickness variation in real time. Other techniques such as in situ discrete wavelength reflectometry or ellipsometry also can be used to determine thickness as well. Control for thickness uniformity and removal of bowing or dishing based on

In a MOCVD process, where the growth of crystals occurs by chemical reaction on the surface of the substrate, the process parameters must be controlled with particular care to ensure that the chemical reaction proceeds under the required conditions. Even small variations in process conditions can adversely affect device quality and production yield. For instance, if a gallium and indium nitride layer is deposited, variations in wafer surface temperature will cause variations in the composition and bandgap of the deposited layer. Because indium has a relatively high vapor pressure, the deposited layer will have a lower proportion of indium and a greater bandgap in those regions of the wafer where the surface temperature is higher. If the deposited layer is an active, light-emitting layer of an LED structure, the emission wavelength of the LEDs formed from the wafer will also vary to an unacceptable degree.

A great deal of effort has been devoted to system design features to minimize temperature variations of the wafers during processing. One challenge encountered in this effort relates to changes in surface profile of the wafers at various stages of processing. In an epitaxial growth process, the materials which form a semiconductor layer are deposited onto the surface of the substrate, forming a generally crystalline structure. The spacing between atoms within a crystal lattice (referred to as the "lattice spacing") depends upon the composition of the crystal. Where the grown layer has a composition different from the composition of the substrate, the deposited layer may have a nominal lattice spacing, different from the lattice spacing of the substrate. In this case, the deposited crystalline layer forms with its lattice spacing stretched or compressed to conform to the lattice spacing of the substrate. As the grown layer is built up, the forces arising from the lattice mismatch at the surface of each wafer cause the wafer to deform.

This deformation tends to take a generally convex or concave shape, depending on the relative physical properties of the grown lattice and of the substrate material. The deformed shape of the wafers causes variations in spacing between the bottom of each wafer and the corresponding pocket floor of the wafer carrier. In turn, these spacing variations affect the heating uniformity of the wafers. This problem has been described in U.S. Pat. No. 7,570,368, the disclosure of which is incorporated by reference herein, which is each directed to measuring and estimating the curvature of wafer deformation. U.S. Pat. No. 8,810,798, the disclosure of which is also incorporated by reference herein, estimates a mean spherical curvature, as well as an azimuthal aspherical curvature deviation of the wafer deformation.

These approaches produce approximations of the curvature of each wafer based on collected measurements. However, in practice each wafer tends to deform in an irregular fashion. Thus, for example, rather than forming spherical bow or even a spherical bow with azimuthal deviation, which can be modeled based on a limited set of measurements, each wafer tends to bow in a unique, but somewhat potato chip-like, form. Moreover, the extent and shape of deformation vary over the course of a process as the grown layers increase and as thermal conditions may vary in the reaction chamber.

In addition to such deformations, overall thickness of a wafer can be difficult to accurately measure using a standard array of optical sensors. In a typical CVD system, viewport access is limited and often multiple distinct sensors are needed to measure the optical characteristics of a particular material due to varying reflectivity, emissivity, or scattering produced by any of the variety of materials that can be made using CVD at any of a variety of wavelengths.

A solution is needed to obtain a more accurate characterization of the in-process wafer deformation and thickness, for which various equipment or processing optimizations might be developed.

### SUMMARY

Aspects of the present invention are defined in the accompanying independent claims. Optional features are set out in the dependent claims.

A device for detecting characteristics of an epitaxially grown structure is disclosed herein. The device includes a primary unit configured to detect a first characteristic of the epitaxially grown structure. The device also includes a secondary unit configured to detect a second characteristic of the epitaxially grown structure, wherein the second characteristic is complementary to the first characteristic. The primary unit and the secondary unit are both arranged in a housing.

In implementations, the housing comprises an engagement feature configured to couple to a rail. Additionally or alternatively, the primary unit is selected from the group consisting of an emissivity-compensated pyrometer, a reflectometer, and a low temperature emissivity-compensated pyrometer. The secondary unit can be selected from the group consisting of a deflectometer, a spectroscopic reflectometer, a pyrometer, and an emissivity-compensated pyrometer to form the complementary counterpart to the primary unit.

In another implementation, a system for detecting characteristics of an epitaxially grown structure is disclosed. The system includes a chemical vapor deposition reactor having a window. The system further includes a rail arranged on the chemical vapor deposition system adjacent the window. The system further includes a housing coupled to the rail. The housing includes a primary unit configured to detect a first characteristic of the epitaxially grown structure through the window. The housing further includes a secondary unit configured to detect a second characteristic of the epitaxially grown structure through the window, wherein the second characteristic is complementary to the first characteristic.

In implementations, the housing comprises an engagement feature and is slidably coupled to the rail. Additionally or alternatively, the primary unit is selected from the group consisting of an emissivity-compensated pyrometer, a reflectometer, and a low temperature emissivity-compensated pyrometer. The secondary unit can be selected from the group consisting of a deflectometer, a spectroscopic reflectometer, a pyrometer, and an emissivity-compensated pyrometer. The system can include a plurality of housings, each of the plurality of housings including a primary unit and a secondary unit configured to detect complementary characteristics. Each of the plurality of housings can be coupled to the rail such that one or more of the plurality of housings can be positioned to detect first and second characteristics through the window while another one or more of the plurality of housings can be positioned away from the window.

According to another implementation, a method for detecting characteristics of an epitaxially grown structure is disclosed. The method includes positioning a housing adjacent a window of a chemical vapor deposition system. The housing includes a primary unit configured to detect a first characteristic of the epitaxially grown structure through the window. The housing also includes a secondary unit configured to detect a second characteristic of the epitaxially grown structure through the window, wherein the second characteristic is complementary to the first characteristic. The method further includes activating the primary unit to detect the first characteristic. The method further includes activating the secondary unit to detect the second characteristic.

In implementations, the primary unit is selected from the group consisting of an emissivity-compensated pyrometer, a reflectometer, and a low temperature emissivity-compensated pyrometer. The secondary unit can be selected from the group consisting of a deflectometer, a spectroscopic reflectometer, a pyrometer, and an emissivity-compensated pyrometer. In implementations, the method can include positioning the housing by sliding the housing along a rail until the housing is adjacent the window. The method can further include sliding the housing away from the window and sliding a second housing adjacent the window, wherein the second housing comprises a tertiary unit configured to detect a third characteristic of the epitaxially grown structure through the window and a quaternary unit configured to detect a fourth characteristic of the epitaxially grown structure through the window, wherein the fourth characteristic is complementary to the third characteristic. In such implementations, the first and second characteristics are detected during a first phase of epitaxial growth, and the third and fourth characteristics are detected during a second phase of epitaxial growth.

The above summary is not intended to describe each illustrated implementation or every implementation of the subject matter hereof. The figures and the detailed description that follow more particularly exemplify various implementations.

### BRIEF DESCRIPTION OF THE DRAWINGS

Subject matter hereof may be more completely understood in consideration of the following detailed description of various implementations in connection with the accompanying figures, in which:
FIG. 1 is a cross-sectional view of a chemical vapor deposition system, according to an implementation.
FIG. 2 is a schematic diagram illustrating in-situ measurement arrangements that obtain two-dimensional tilt angle measurements from the surface of wafers during processing via a deflectometer instrument according to an implementation.
FIG. 3 is a cross-sectional view of a device for detecting optical characteristics of an object generated by chemical vapor deposition according to one implementation.
FIG. 4 is a mounting system for providing optical detection on a window of a chemical vapor deposition system according to an implementation.
FIG. 5 is a cutaway view of a reactor lid including a detector according to an implementation.

While various implementations are amenable to various modifications and alternative forms, specifics thereof have been shown by way of example in the drawings and will be described in detail. It should be understood, however, that the intention is not to limit the claimed inventions to the particular implementations described. On the contrary, the intention is to cover all modifications, equivalents, and alternatives falling within the scope of the subject matter as defined by the claims.

### DETAILED DESCRIPTION OF THE DRAWINGS

Sensor systems described herein are capable of detecting attributes of a deposited structure in a chemical vapor deposition (CVD) system, including temperature and shape. The sensor systems can detect these attributes for a variety of types of deposited structures, at a variety of operating conditions. In addition to this versatility, the detector systems use relatively little viewport space due to the unique and novel combinations of sensors and optical components described herein.

CVD systems can be used to generate epitaxially grown structures formed by the reaction of precursor gases that are combined at a heated surface. The chamber in which these precursor gases combine is referred to herein as a reactor, and the heated surface as a susceptor or a wafer carrier. There are a variety of CVD reactor types that are designed for a variety of purposes, such as the metal-oxide CVD (MOCVD) systems described above. Different types of CVD can use different operating temperatures, different mechanical configurations, and require different inputs or appurtenances to the reactor itself. One commonality to most or perhaps all CVD systems, however, is the desire to control the features of the epitaxially grown structures, which includes attributes such as thickness, surface roughness, composition, and curvature (such as "dishing" or "bowing").

Each of these features can be controlled with appropriate adjustments to the operating settings of a CVD reactor. For example, the reactor temperature can be modified, or the relative proportions of the precursor gases can be changed, or the location where the gas is input into the reactor chamber can be changed, the rotation speed of a susceptor can be changed, or in some circumstances (such as when the desired wafer thickness has been reached) the CVD process can be stopped altogether. The specific actions that might be taken depend on the particular structure being grown and the desires of the CVD operator.

In order to take any of such action, monitoring of these features of the epitaxially-grown structure or structures must be accurately measured. In a typical CVD system, there is limited access to the interior of the reactor for sensors or detectors. In a typical CVD reactor, there may be one or more "windows" or visual access points on a top surface of the reactor. "Top," in this context, can refer to the top surface of the reactor from a gravitational reference frame, or more generally in some implementations it can refer to the direction from which the precursor flows towards the susceptor.

Each of the features that an operator wishes to measure from the exterior of the reactor requires some access to a window. Thus it is often the case that an operator must choose which features are most important while not measuring others, or sensors must be swapped in and out of the available window positions in order to measure all of the required information to ensure a particular quality metric. If a metric is missed, such as if the composition of a wafer strays too far from the target composition, then the entire wafer (or batch of wafers) may need to be scrapped. Thus simultaneous monitoring of all of the critical features of the wafer as it being grown is critical to reduce lost time and resources, but conventional systems rely on interpolation and projections rather than consistent monitoring due to the limits of window space that is accessible.

This problem can be exacerbated in scenarios in which a single reactor is used for manufacture of multiple types of wafers or other epitaxially-grown structures. Some detectors are useful only for particular types of materials or at certain temperatures. For example, different materials may be reflective only within certain wavelength regions that are mutually exclusive with the wavelengths at which other materials are reflective. In that case, a detector that is well suited for detecting the thickness of one material based on time-of-flight or phase shift detection in a reflected beam would be completely unsuited for use with the other material that will not reflect the beam. Therefore the detector either takes up valuable window space and provides no useful information related to growth of the second material, or an operator must change out the detector and replace it with a different one that is better suited to detecting the thickness of the second material.

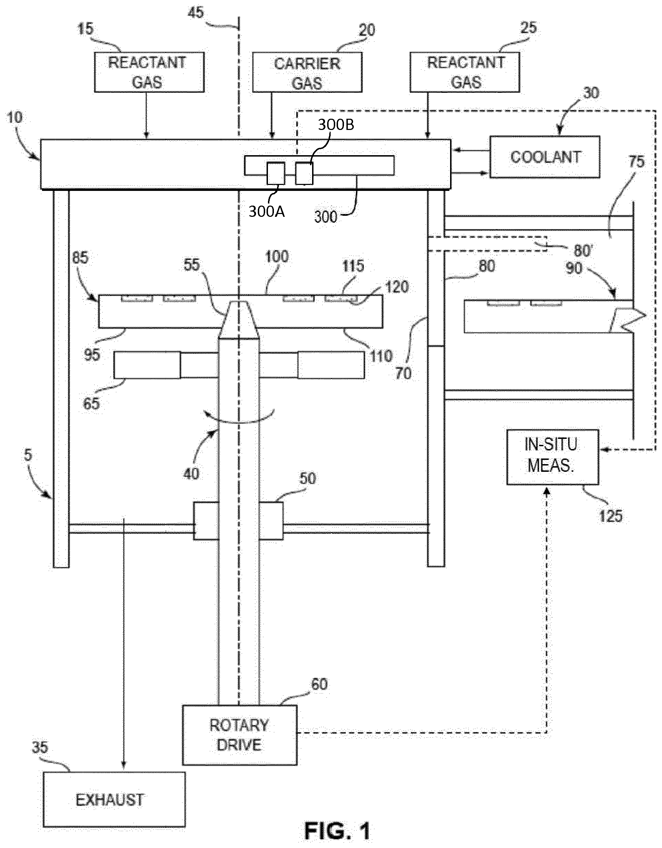

As described in detail below with respect to the implementations corresponding to FIGS. 1-5, systems and methods for metrology using multiple measurement techniques remedy these deficiencies by combining diverse sensors and detectors in a common system such that tools used on mutually exclusive materials or at mutually exclusive temperatures or other operating conditions share a beam path. Thus the window space available for a reactor is used more efficiently, reducing time requirements on the operator for swapping out and calibrating detector equipment, and also preventing wasted space on the reactor windows.

FIG. 1 illustrates a chemical vapor deposition apparatus in accordance with one implementation. Reaction chamber 5 has an enclosure that defines a process environment space. Gas distribution device 10 is arranged at one end of the chamber. The end having gas distribution device 10 is referred to herein as the "top" end of reaction chamber 5. This end of the chamber typically, but not necessarily, is disposed at the top of the chamber in the normal gravitational frame of reference. Thus, the downward direction as used herein refers to the direction away from gas distribution device 10; whereas the upward direction refers to the direction within the chamber, toward gas distribution device 10, regardless of whether these directions are aligned with the gravitational upward and downward directions. Similarly, the "top" and "bottom" surfaces of elements are described herein with reference to the frame of reference of reaction chamber 5 and gas distribution device 10.

Gas distribution device 10 is connected to sources 15, 20, and 25 for supplying process gases to be used in the wafer treatment process, such as a carrier gas and reactant gases, such as a metalorganic compound and a source of a group V metal. Gas distribution device 10 is arranged to receive the various gases and direct a flow of process gasses generally in the downward direction. Gas distribution device 10 desirably is also connected to coolant system 30 arranged to circulate a liquid through gas distribution device 10 so as to maintain the temperature of the gas distribution device at a desired temperature during operation. A similar coolant arrangement (not shown) can be provided for cooling the walls of reaction chamber 5. Reaction chamber 5 is also equipped with exhaust system 35 arranged to remove spent gases from the interior of the chamber through ports (not shown) at or near the bottom of the chamber so as to permit continuous flow of gas in the downward direction from gas distribution device 10.

An example of a suitable rotation system includes spindle 40, which is arranged within the chamber so that the central axis 45 of spindle 40 extends in the upward and downward directions. Spindle 40 is mounted to the chamber by a conventional rotary pass-through device 50 incorporating bearings and seals (not shown) so that spindle 40 can rotate about central axis 45, while maintaining a seal between spindle 40 and the wall of reaction chamber 5. The spindle has fitting 55 at its top end, i.e., at the end of the spindle closest to gas distribution device 10. As further discussed below, fitting 55 is an example of a wafer carrier retention mechanism adapted to releasably engage a wafer carrier. Spindle 40 is connected to rotary drive mechanism 60 such as an electric motor drive, which is arranged to rotate spindle 40 about central axis 45.

Heating element 65 is mounted within the chamber and surrounds spindle 40 below fitting 55. Reaction chamber 5 is also provided with entry opening 70 leading to antechamber 75, and door 80 for closing and opening the entry opening. Door 80 is depicted only schematically in FIG. 1, and is shown as movable between the closed position shown in solid lines, in which the door isolates the interior of reaction chamber 5 from antechamber 75, and an open position shown in broken lines at 80'. The door 80 is equipped with an appropriate control and actuation mechanism for moving it between the open position and closed positions. In practice, the door may include a shutter movable in the upward and downward. The apparatus depicted in FIG. 1 may further include a loading mechanism (not shown) capable of moving a wafer carrier from the antechamber 75 into the chamber and engaging the wafer carrier with spindle 40 in the operative condition, and also capable of moving a wafer carrier off of spindle 40 and into antechamber 75.

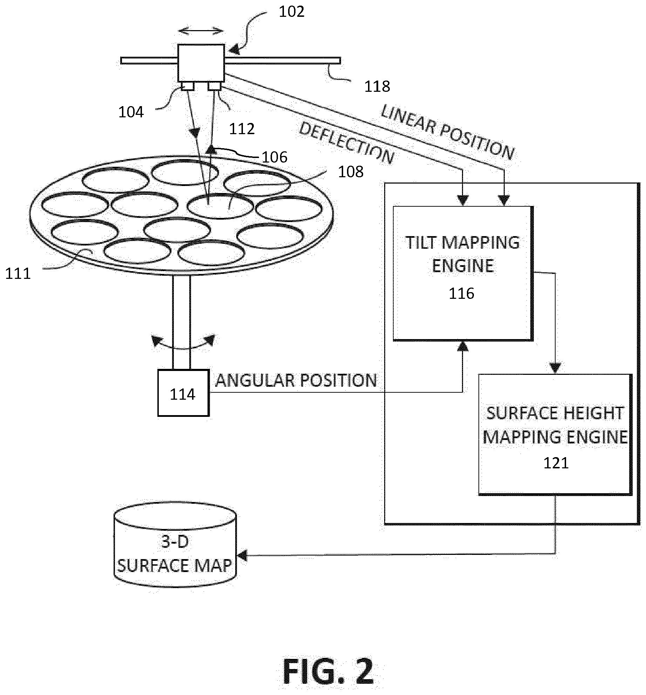

The apparatus according to the example depicted also includes a plurality of wafer carriers. In the operating condition shown in FIG. 1, a first wafer carrier 85 is disposed inside reaction chamber 5 in an operative position, whereas a second wafer carrier 90 is disposed within antechamber 75. Each wafer carrier includes body 95 which is substantially in the form of a circular disc having a central axis (See FIG. 2). Body 95 is formed symmetrically about central axis. In the operative position, the central axis of the wafer carrier body is coincident with central axis 45 of spindle 40. Body 95 is desirably formed from materials which do not contaminate the process and which can withstand the temperatures encountered in the process. For example, the larger portion of the disc may be formed largely or entirely from materials such as graphite, silicon carbide, or other refractory materials. Body 95 generally has a planar top surface 100 and a bottom surface 110 extending generally parallel to one another and generally perpendicular to the central axis of the disc. Body 95 also has one, or a plurality, of wafer-holding features adapted to hold a plurality of wafers.

In operation, wafer 115, such as a disc-like wafer formed from sapphire, silicon carbide, or other crystalline substrate, is disposed within each pocket 120 of each wafer carrier. Typically, wafer 115 has a thickness which is small in comparison to the dimensions of its major surfaces. For example, a circular wafer of about 2 inches (50 mm) in diameter may be about 430 µm thick or less. As illustrated in FIG. 1, wafer 115 is disposed with a top surface facing upwardly, so that the top surface is exposed at the top of the wafer carrier. It should be noted that in various implementations, wafer carrier 85 carries different quantities of wafers. For instance, in one example implementation, wafer carrier 85 can be adapted to hold six wafers. In another example implementation, as shown in FIG. 2, the wafer carrier holds 12 wafers.

In a typical MOCVD process, wafer carrier 85 with wafers loaded thereon is loaded from antechamber 75 into reaction chamber 5 and placed in the operative position shown in FIG. 1. In this condition, the top surfaces of the wafers face upwardly, towards gas distribution device 10. Heating element 65 is actuated, and rotary drive mechanism 60 operates to turn spindle 40 and hence wafer carrier 85 around axis 45. Typically, spindle 40 is rotated at a rotational speed from about 50-1500 revolutions per minute. Process gas supply units 15, 20, and 25 are actuated to supply gases through gas distribution device 10. The gases pass downwardly toward wafer carrier 85, over top surface 100 of wafer carrier 85 and wafers 115, and downwardly around the periphery of the wafer carrier to the outlet and to exhaust system 50. Thus, the top surface of the wafer carrier and the top surfaces of wafer 115 are exposed to a process gas including a mixture of the various gases supplied by the various process gas supply units. Most typically, the process gas at the top surface is predominantly composed of the carrier gas supplied by carrier gas supply unit 20. In a typical chemical vapor deposition process, the carrier gas may be nitrogen, and hence the process gas at the top surface of the wafer carrier is predominantly composed of nitrogen with some amount of the reactive gas components.

Heating elements 65 transfer heat to the bottom surface 110 of wafer carrier 85, principally by radiant heat transfer. The heat applied to the bottom surface of wafer carrier 85 flows upwardly through the body 95 of the wafer carrier to the top surface 100 of the wafer carrier. Heat passing upwardly through the body also passes upwardly through gaps to the bottom surface of each wafer, and upwardly through the wafer to the top surface of wafer 115. Heat is radiated from the top surface 100 of wafer carrier 85 and from the top surfaces of the wafer to the colder elements of the process chamber as, for example, to the walls of the process chamber and to gas distribution device 10. Heat is also transferred from the top surface 100 of wafer carrier 85 and the top surfaces of the wafers to the process gas passing over these surfaces.

In a related implementation (not shown in FIG. 1), wafer carrier 85 is mounted on a rotatable platform or other retention structure, such as a turntable or rotating tube structure that contacts the wafer carrier only at or near its edges, in lieu of spindle 40.

In another related implementation (also not shown in FIG. 1), the system is designed to operate on one single wafer and hence does not require a wafer carrier. In this latter type of implementation, the wafer is retained by one or more retention features of the turntable or rotating tube. In the broader sense, the spindle, turntable, or rotating tube, along with the necessary mechanics to impart and control rotational motion thereof, can be regarded as a rotation system.

In the implementation depicted, the system includes various sensors and associated measurement hardware to perform in-situ measurements of physical parameters, as described in more detail with respect to FIGS. 2-5. As illustrated schematically in FIG. 1, in-situ measurement controller 125 obtains data from one or more sensors 300A and 300B, as well as positional information from those sensors representing the respective location of the sensors, where relevant. In addition, in-situ measurement controller 125 receives wafer carrier positional information, which in one implementation can come from rotary drive mechanism 60. The wafer carrier positional information represents an angular position of the wafer carrier, from which the relative position of a given sensor (e.g., 300A or 300B) and a given wafer 115 can be discerned. With this information, in-situ measurement controller 125 computes the in-situ measurement data that may be mapped to specific points on the wafers 115 or wafer carrier 85. Sensors 300A and 300B can be combined as described below to include multiple, complementary types of detection systems.

In a related implementation, sensors 300A and 300B are mounted on a scanning positioner 300, which can be a rail as described in more detail below. Scanning positioner 300, which is described in greater detail below, includes a mechanism arranged to move one or more sensors 300A and 300B, or other sensors, to different positions over wafer carrier 100.

In a single reactor, typically one or more viewports are arranged facing wafer carrier 85 from outside of the chamber 5 (i.e., passing between gas injectors associated with reactant gas and carrier gas 15, 20, and 25). Viewports can be made of a material that prevents fluid communication between the interior of the chamber 5 and an outside environment, while still permitting transmission of electromagnetic signal such as the optical signals described above with respect to reflectometers, pyrometers, deflectometers, and spectroscopic tools. In commercial CVD reactors, this viewport is limited to at most four access points (two on each side).

Some tools, as described above, can operate at wavelengths that correspond to certain temperatures. Thus if a 1090 nm tool is installed but the reactor is producing GaN wafers, for example, the tool will be practicably useless, since GaN absorbs 1090 nm light. Contrariwise, if the reactor is operating at relatively low temperature where the 1090 nm tool is useful, the 405 nm tool designed for use with GaN deposition will be practicably useless, because the amount of radiation collected by a low-wavelength sensor in a low-temperature system is not sufficient to generate useful information.

Some examples of sensors and detectors of the following types are described herein:

### Reflectometry

Emissivity can be calculated at a specific wavelength with a reflectometer. Emissivity is a physical property of a material. Each material has an emissivity of between 0 (no emission whatsoever) and 1 (a perfect blackbody). By selecting an appropriate wavelength at which the surface being analyzed is not transmissive, emissivity can also be used to calculate reflectivity. One common wavelength is 385 nm reflectometry.

Reflectometers are used to determine surface roughness of a wafer or other epitaxially-grown structure. In general, smooth wafers will generate a more specular reflection, whereas rougher surfaces will produce a less specular reflection. Therefore the sharpness and clarity of a reflected beam can be used as an indicator of the smoothness of a surface. The emissivity of a sample as detected with a reflectometer can also be used with pyrometer data for an accurate temperature measurement, as described in more detail below. Roughness determinations are typically conducted using a reflectometer operating at a relatively low wavelength, such as 385 nm.

### Pyrometry

Pyrometry uses the emission generated by an object as an indicator of various features including the temperature of that object. Each temperature has a corresponding blackbody radiation spectrum and by detecting the spectrum the temperature of that object can be determined to a high degree of accuracy. Broad spectrum detection (i.e., detecting the entire blackbody radiation curve) is not typically necessary. Rather, by measuring at a single wavelength, the remainder of the curve can be inferred. The particular wavelength selected for measurement will provide greater accuracy the closer it is to the peak of the blackbody curve. Therefore a lower temperatures, pyrometry will be more accurate if the detector is sensitive to a higher wavelength. Conversely, if a reactor is operating at a higher temperature, it is desirable to operate the pyrometer at a lower wavelength that is closer to the peak of the blackbody radiation curve corresponding to that temperature.

Pyrometers used in CVD often include a 930 nm detector. 930 nm is near enough to the peak of the blackbody emission curves associated with typical semiconductor deposition temperatures to provide a good indicator of the temperature of the inside of the reactor. Another common wavelength used by detectors in CVD pyrometry is 405 nm, which corresponds to the higher temperatures used in gallium nitride (GaN) deposition, for example. Another common wavelength used by detectors in CVD pyrometry is 1090 nm, which corresponds to the lower temperatures used in Arsenic-Phosphorous (AsP) materials.

Pyrometers, as opposed to emissivity-compensated pyrometers described in more detail below, are used frequently for deposition of GaN films. The reason for this is that GaN films absorb radiation in the 405nm band quite well, such that radiation signal only comes from the skin depth of the top of the film. Since deposition occurs at this very film surface, pyrometry is a good tool for detecting the most relevant temperature in the GaN system even without further measurements of emissivity.

### Spectroscopic reflectometry

A spectroscopic reflectometer is a type of device that uses a broad band signal, such as a broad band LEG. The intensity and wavelength of light reflected from a sample is compared to the intensity at each wavelength of the light directed towards the sample to determine thickness of thin films (such as epitaxially grown layers). The probe beam is partially reflected and partially transmitted at the top surface. That probe beam is now split into two components, the reflected part and the transmitted part. At the bottom of the thin film, the transmitted part will be returned and recombine with the reflected part.

For thin films, the separation and recombination of the reflected and transmitted parts of the probe beam can result in interference that is either constructive or destructive based upon the path length of the transmitted part of the probe beam through the thin film and back. Therefore spectroscopic reflectometry can be used as a thickness measurement technique using any of a variety of wavelengths, or at multiple wavelengths simultaneously.

### Deflectometry

A deflectometer includes both an emitter and a sensor, wherein the sensor is calibrated to receive a reflected beam from the emitter at a specific point after reflection from a sample. If the sample deviates from a perfectly flat, level surface, the resulting deflection of the sensed beam can be detected to determine the tilt of the sample. In CVD systems, this can be helpful to detect wafer tilt, bowing or dishing, or stress on the wafer. Typical CVD deflectometers use a laser diode having a defined wavelength such as 532 nm or 635 nm. Unlike some other devices described herein, it is important that the deflectometer operate at a wavelength that will be reflected by the surface of the sample, rather than transmitted or absorbed, so that the returned beam will have accurate and sufficiently strong signal for the deflectometer to function.

FIG. 2 is a block diagram illustrating in-situ measurement arrangements that obtain two-dimensional tilt angle measurements from the surface of wafers during processing via a deflectometer 102 according to an implementation. A deflectometer such as the deflectometer 102 shown in FIG. 2 operates by directing a beam of light at a known angle toward a sample. In FIG. 2, this beam of light is depicted with an arrow emanating from light source 104, which is reflected as reflected light source 106. The light from light source 104 is also controlled for wavelength, such that it will be reflected rather than absorbed or transmitted at the top surface of an epitaxially-grown structure like wafer 108 of FIG. 2. In implementations some portion of the light from light source 104 can be reflected as reflected light source 106 while another portion is refracted. Depending on the wafer carrier surface material, the incident beam may or may not reflect from the portions of the top surface of wafer carrier 111 that are not covered by wafers 108. The reflected beam 106 is reflected generally towards beam deflection sensor 112. In one detector design, detector 112 measures deflection from a predicted location where, if the wafer 108 were a perfectly flat mirror, the reflected light source 106 would be expected to arrive. If the received light at detector 112 is offset from this location, it is an indication that there is some curvature to the wafer 108.

In practice, a motor 114 constantly rotates wafer carrier 111 such that the angular position at which deflectometer 102 is making its measurement changes over time. As shown in FIG. 2, the angular position from motor 114 is provided to a tilt mapping engine 116. In alternative implementations, motor 114 can provide angular momentum information rather than angular position, or the position of wafer carrier 111 can be determined by detector 106 based on the periodic nature of the data gleaned from movement of the received light at detector 112. In one implementation, linear positioner 118 includes a track, a rail, a channel, or other suitable guide along which deflectometer 102 traverses. Motion can be provided by any suitable mechanical arrangement, such as via belt or chain drive, pulley, screw, gear, linear motor, or the like (or any combination thereof).

As shown in FIG. 2, tilt mapping engine 116 receives information from motor 114 and from deflectometer 102 related to the deflection of the reflected light beam and the angular position of the wafer carrier 111. From this information the bowing or tilt of different portions of the wafers 108 can be determined. The same information can also be used by a surface height mapping engine 121 to determine the overall thickness of the wafer or wafers.

### Emissivity-compensatedpyrometry (Reflectometry + Pyrometry)

Deposition processes for many epitaxially grown structures, including for example compound semiconductors devices (such as InGaAsP/InP infrared laser diodes or InGaP/GaAs heterojunction bipolar transistors), are extremely temperature sensitive with temperature windows as small as 2 °C to 3 °C. Requirements for process temperature repeatability can be less than ± 0.25 °C at temperatures in the range ~ 650 °C to 750 °C for some systems. Temperature control is a vital requirement for growing reproducible structures, and wafer temperatures can deviate significantly from those measured by conventional techniques such as close proximity thermocouples or optical pyrometers. Optical pyrometer measurements can have error ranges up to 100 °C due to emissivity oscillations during deposition of the thin epitaxial layers. To overcome these problems, measurements from a pyrometer can be combined with measurements from a reflectometer capable of collecting accurate, real-time emissivity measurements. This more accurate temperature data can be used for real-time wafer surface temperature control.

The intensity of radiation emitted from an object is a function of its temperature, wavelength, and emissivity. Therefore, by combining the emissivity data from a reflectometer (indicating how strong the blackbody radiation from a sample will be) and emission data from a pyrometer (indicating how much actual omission occurred at a specific wavelength), the temperature of a sample can be detected to a very high level of accuracy.

Other implementations can incorporate both pyrometry and emissivity-compensated pyrometry at a separate wavelength for specific tasks. For example, multiple quantum well (MQW) growth can be aided by detection of both surface skin temperature and accurate system-wide temperature detection. Therefore in a GaN MQW growth system it is beneficial to use both 405 nm pyrometry to detect skin depth temperature and, for example, 930 nm emissivity-compensated pyrometry to detect the overall system temperature for correct control.

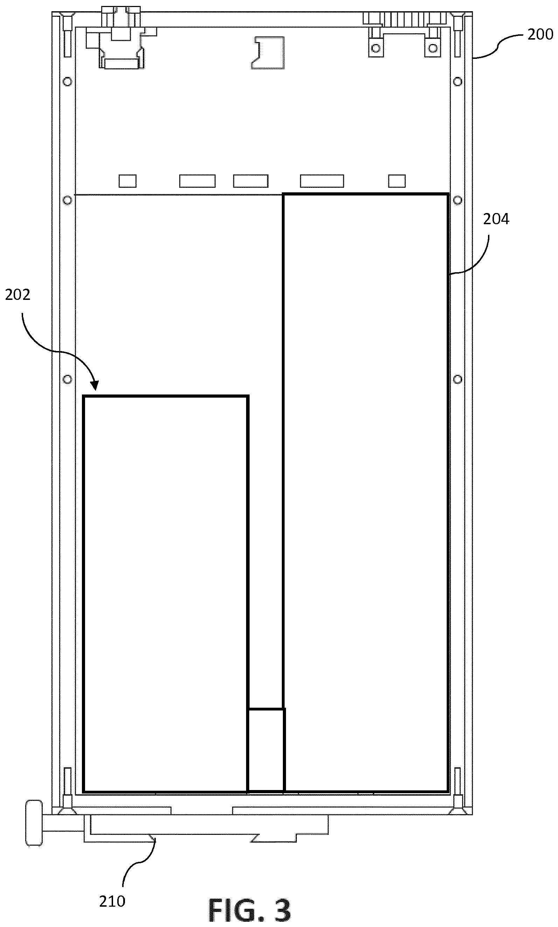

FIG. 3 is a cross-sectional view of a system for detecting multiple features of an epitaxially-grown wafer according to an implementation. As shown in FIG. 3, a primary unit 202 and a secondary unit 204 are arranged in a common housing 200. In the implementation shown in FIG. 3, primary unit 202 is, for example, a reflectometer, while secondary unit 204 is, for example, a deflectometer. Deflectometer 204 can operate at a predetermined wavelength and produce a collimated light beam, as described with respect to FIG. 2. For example, deflectometer 204 can operate at 532 nm, 635 nm, or another wavelength that is chosen to correspond with reflectivity of a sample that is being grown.

In alternative implementations, various other combinations of reflectometer and deflectometer could be used. Table 1, below, depicts some other particularly useful combinations of instruments that can be used in the positions of primary unit 202 and secondary unit 204.

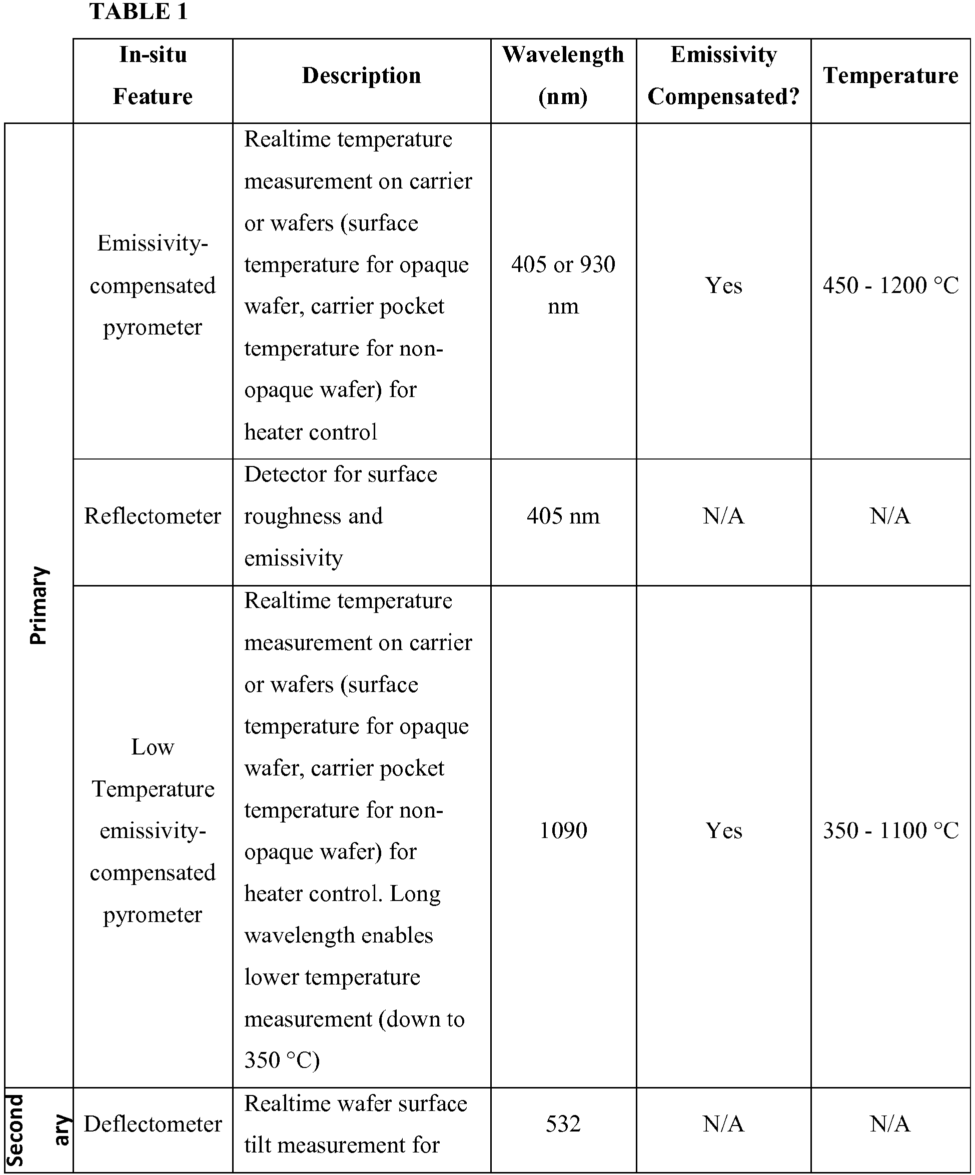

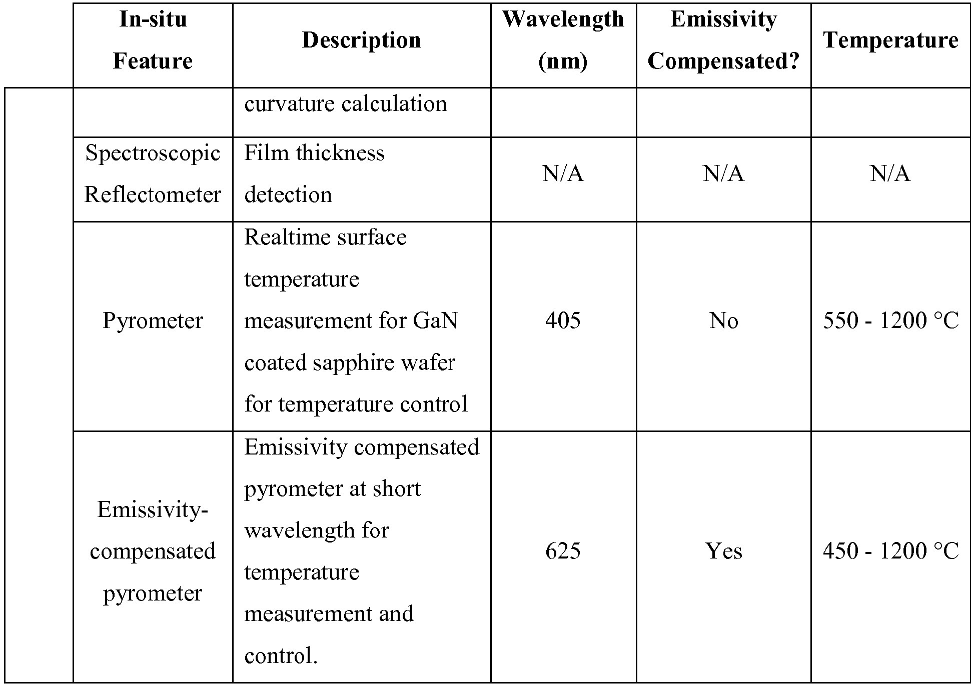

The combinations described herein are advantageous because the primary unit 202 and secondary unit 204 are configured to provide useful combinations of information while reducing the required amount of viewport use. Primary unit 202 can provide emissivity-compensated pyrometry readings at any of a wide range of temperatures, either at 405 nm, 930 nm, or 1090 nm. Likewise, primary unit 202 can provide roughness or emissivity data. Secondary unit 204 can provide deflectometry data (tilt), spectroscopic reflectometry data (film thickness), of supplemental emissivity-compensated pyrometry (for detecting temperatures at short wavelengths when reflectometry variation is large).

In a typical processing system, only one of the types of information that can be gathered using primary unit 202 is typically necessary at any given time. Likewise, only one of the types of information that can be gathered using secondary unit 204 is typically necessary at any given time. By selecting the appropriate tools to use in primary unit 202 and 204, useful combinations of information can be gathered without requiring the installation of a variety of different tools on the viewport, only some of which are actually used at a given time in a given process. For example, a combined unit might use 930 nm emissivity-compensated pyrometry (to detect unit operating temperature) in the primary unit 202 and 405 nm pyrometry (to detect surface temperature) during epitaxial growth of a wafer having multiple quantum wells (MQW).

This combination of first and second characteristics from the primary unit 202 and secondary unit 204, respectively, are therefore complementary with one another. They are complementary in that the types of data gathered by the primary unit 202 are commonly used in concert with the types of data gathered by the secondary unit 204. The various types of data gathered by the primary unit 202 are not complementary to one another, in that they are not used together. Likewise, the various types of data that are gathered by the secondary unit 204 are not complementary to one another.

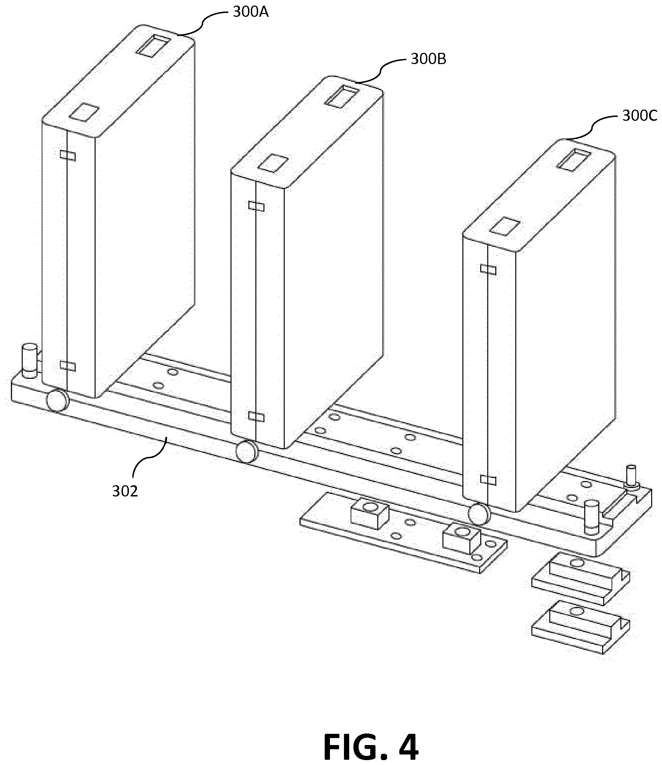

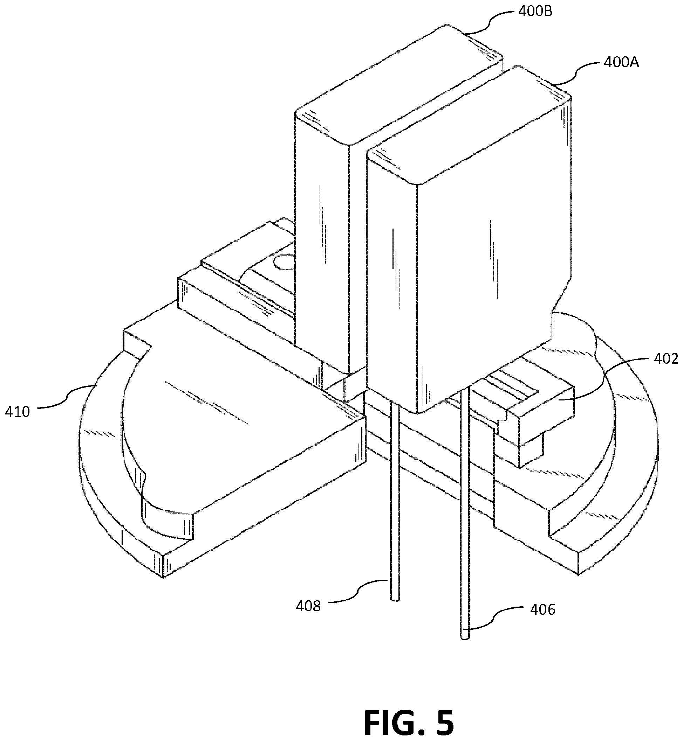

Housing 200 includes cleat 210 that is configured to attach to an adjacent structure, such as a rail. The attachment to the rail is described in more detail below with respect to FIGS. 4 and 5.

FIG. 4 shows a series of housings (300A, 300B, 300C) mounted on a rail 302. Rail 302 can be used for in-situ mounting of each of the housings 300A-300C, so that they can be positioned at the viewport of a reactor (not shown) beneath rail 302. For example, first housing 300A can contain a set of sensors that are used during system warm-up, housing 300B can contain a set of sensors that are used during deposition of a first type of epitaxially grown structures, and second housing 300C can be used during deposition of a second type of epitaxially grown structures. Housings 300A-300C can have engagement features such as wheels, grooves, or tabs that are configured to engage with rail 302. In implementations, housings 300A-300C are slidably coupled to the rail 302 such that they can be moved into or out of position at the window as desired.

FIG. 5 shows similar structures compared to those described with respect to FIG. 4. In particular, FIG. 5 shows two housings (400A and 400B) attached to a rail 402. First housing 400A defines a beam path 406 that extends through a window in reactor lid 410. In the view shown in FIG. 5, the window is not depicted because reactor lid 410 is cut away. Likewise, second housing 400B defines a beam path 408 that extends through the window in reactor lid 410. Each of the beam paths 406, 408 corresponds to two measurement devices, as described above with respect to FIG. 3. Accordingly, in the system shown in FIG. 5 up to four types of data can be acquired. The four types of data can correspond to any two of the items from the "primary" columns in Table 1, above, while the two other items are selected from the "secondary" table. Thus, as shown in FIG. 5, almost any useful combination of data for chemical vapor deposition can be selected while use of the viewport is low.

Various implementations of systems, devices, and methods have been described herein. These implementations are given only by way of example and are not intended to limit the scope of the claimed inventions. It should be appreciated, moreover, that the various features of the implementations that have been described may be combined in various ways to produce numerous additional implementations. Moreover, while various materials, dimensions, shapes, configurations and locations, etc. have been described for use with disclosed implementations, others besides those disclosed may be utilized without exceeding the scope of the claimed inventions.

Persons of ordinary skill in the relevant arts will recognize that the subject matter hereof may comprise fewer features than illustrated in any individual implementation described above. The implementations described herein are not meant to be an exhaustive presentation of the ways in which the various features of the subject matter hereof may be combined. Accordingly, the implementations are not mutually exclusive combinations of features; rather, the various implementations can comprise a combination of different individual features selected from different individual implementations, as understood by persons of ordinary skill in the art. Moreover, elements described with respect to one implementation can be implemented in other implementations even when not described in such implementations unless otherwise noted.

Although a dependent claim may refer in the claims to a specific combination with one or more other claims, other implementations can also include a combination of the dependent claim with the subject matter of each other dependent claim or a combination of one or more features with other dependent or independent claims. Such combinations are proposed herein unless it is stated that a specific combination is not intended.

Any incorporation by reference of documents above is limited such that no subject matter is incorporated that is contrary to the explicit disclosure herein. Any incorporation by reference of documents above is further limited such that no claims included in the documents are incorporated by reference herein. Any incorporation by reference of documents above is yet further limited such that any definitions provided in the documents are not incorporated by reference herein unless expressly included herein.

For purposes of interpreting the claims, it is expressly intended that the provisions of 35 U.S.C. § 112(f) are not to be invoked unless the specific terms "means for" or "step for" are recited in a claim.

The following items are disclosed herein:
1. A device for detecting characteristics of an epitaxially grown structure in a chemical vapor deposition system, the device comprising
   a housing;
   a primary unit configured to detect a first characteristic of the epitaxially grown structure;
   a secondary unit configured to detect a second characteristic of the epitaxially grown structure, wherein the second characteristic is complementary to the first characteristic,
   wherein the primary unit and the secondary unit are both arranged in the housing.
2. The device of item 1, wherein the housing comprises an engagement feature configured to couple to a rail.
3. The device of item 1 or item 2, wherein the primary unit is selected from the group consisting of an emissivity-compensated pyrometer, a reflectometer, and a low temperature emissivity-compensated pyrometer.
4. The device of any of items 1 to 3, wherein the secondary unit is selected from the group consisting of a deflectometer, a spectroscopic reflectometer, a pyrometer, and an emissivity-compensated pyrometer.
5. A system for detecting characteristics of an epitaxially grown structure in a chemical vapor deposition system, the system comprising:
   a chemical vapor deposition reactor having a window;
   a rail arranged on the chemical vapor deposition system adjacent the window; and
   a housing coupled to the rail, wherein the housing includes:
      a primary unit configured to detect a first characteristic of the epitaxially grown structure through the window; and
      a secondary unit configured to detect a second characteristic of the epitaxially grown structure through the window, wherein the second characteristic is complementary to the first characteristic.
6. The system of item 5, wherein the housing comprises an engagement feature and is slidably coupled to the rail.
7. The system of item 5 or item 6, wherein the primary unit is selected from the group consisting of an emissivity-compensated pyrometer, a reflectometer, and a low temperature emissivity-compensated pyrometer.
8. The system of any of items 5 to 7, wherein the secondary unit is selected from the group consisting of a deflectometer, a spectroscopic reflectometer, a pyrometer, and an emissivity-compensated pyrometer.
9. The system of any of item 5 to 8, wherein the system comprises a plurality of housings, each of the plurality of housings including a primary unit and a secondary unit configured to detect complementary characteristics.
10. The system of item 9, wherein each of the plurality of housings are coupled to the rail such that one or more of the plurality of housings can be positioned to detect first and second characteristics through the window while another one or more of the plurality of housings can be positioned away from the window.
11. A method for detecting characteristics of an epitaxially grown structure in a chemical vapor deposition system, the method comprising:
   positioning a housing adjacent a window of the chemical vapor deposition system, the housing having:
      a primary unit configured to detect a first characteristic of the epitaxially grown structure through the window; and
      a secondary unit configured to detect a second characteristic of the epitaxially grown structure through the window, wherein the second characteristic is complementary to the first characteristic
   activating the primary unit to detect the first characteristic; and
   activating the secondary unit to detect the second characteristic.
12. The method of item 11, wherein the primary unit is selected from the group consisting of an emissivity-compensated pyrometer, a reflectometer, and a low temperature emissivity-compensated pyrometer.
13. The method of item 11 or item 12, wherein the secondary unit is selected from the group consisting of a deflectometer, a spectroscopic reflectometer, a pyrometer, and an emissivity-compensated pyrometer.
14. The method of any of items 11 to 13, wherein positioning the housing comprises sliding the housing along a rail until the housing is adjacent the window.
15. The method of item 14, further comprising sliding the housing away from the window and sliding a second housing adjacent the window, wherein the second housing comprises:
   a tertiary unit configured to detect a third characteristic of the epitaxially grown structure through the window; and
   a quaternary unit configured to detect a fourth characteristic of the epitaxially grown structure through the window, wherein the fourth characteristic is complementary to the third characteristic.
16. The method of item 15, wherein the first and second characteristics are detected during a first phase of epitaxial growth, and the third and fourth characteristics are detected during a second phase of epitaxial growth.

The above implementations have been described by way of example only, and the described implementations and arrangements are to be considered in all respects only as illustrative and not restrictive. It will be appreciated that variations of the described implementations and arrangements may be made without departing from the scope of the invention.

## Claims

1. A device for detecting characteristics of an epitaxially grown structure in a chemical vapor deposition system, the device comprising
a housing;
a primary unit configured to detect a first characteristic of the epitaxially grown structure;
a secondary unit configured to detect a second characteristic of the epitaxially grown structure, wherein the second characteristic is complementary to the first characteristic,
wherein the primary unit and the secondary unit are both arranged in the housing.

2. The device of claim 1, wherein the housing comprises an engagement feature configured to couple to a rail.

3. The device of claim 1, wherein the primary unit is selected from the group consisting of an emissivity-compensated pyrometer, a reflectometer, and a low temperature emissivity-compensated pyrometer.

4. The device of claim 1, wherein the secondary unit is selected from the group consisting of a deflectometer, a spectroscopic reflectometer, a pyrometer, and an emissivity-compensated pyrometer.

5. A system for detecting characteristics of an epitaxially grown structure in a chemical vapor deposition system, the system comprising:
a chemical vapor deposition reactor having a window;
a rail arranged on the chemical vapor deposition system adjacent the window; and
a housing coupled to the rail, wherein the housing includes:
a primary unit configured to detect a first characteristic of the epitaxially grown structure through the window; and
a secondary unit configured to detect a second characteristic of the epitaxially grown structure through the window, wherein the second characteristic is complementary to the first characteristic.

6. The system of claim 5, wherein the housing comprises an engagement feature and is slidably coupled to the rail.

7. The system of claim 5, wherein the primary unit is selected from the group consisting of an emissivity-compensated pyrometer, a reflectometer, and a low temperature emissivity-compensated pyrometer.

8. The system of claim 5, wherein the secondary unit is selected from the group consisting of a deflectometer, a spectroscopic reflectometer, a pyrometer, and an emissivity-compensated pyrometer.

9. The system of claim 5, wherein the system comprises a plurality of housings, each of the plurality of housings including a primary unit and a secondary unit configured to detect complementary characteristics.

10. The system of claim 9, wherein each of the plurality of housings are coupled to the rail such that one or more of the plurality of housings can be positioned to detect first and second characteristics through the window while another one or more of the plurality of housings can be positioned away from the window.

11. A method for detecting characteristics of an epitaxially grown structure in a chemical vapor deposition system, the method comprising:
positioning a housing adjacent a window of the chemical vapor deposition system, the housing having:
a primary unit configured to detect a first characteristic of the epitaxially grown structure through the window; and
a secondary unit configured to detect a second characteristic of the epitaxially grown structure through the window, wherein the second characteristic is complementary to the first characteristic
activating the primary unit to detect the first characteristic; and
activating the secondary unit to detect the second characteristic.

12. The method of claim 11, wherein the primary unit is selected from the group consisting of an emissivity-compensated pyrometer, a reflectometer, and a low temperature emissivity-compensated pyrometer.

13. The method of claim 11, wherein the secondary unit is selected from the group consisting of a deflectometer, a spectroscopic reflectometer, a pyrometer, and an emissivity-compensated pyrometer.

14. The method of claim 11, wherein positioning the housing comprises sliding the housing along a rail until the housing is adjacent the window.

15. The method of claim 14, further comprising sliding the housing away from the window and sliding a second housing adjacent the window, wherein the second housing comprises:
a tertiary unit configured to detect a third characteristic of the epitaxially grown structure through the window; and
a quaternary unit configured to detect a fourth characteristic of the epitaxially grown structure through the window, wherein the fourth characteristic is complementary to the third characteristic.

16. The method of claim 15, wherein the first and second characteristics are detected during a first phase of epitaxial growth, and the third and fourth characteristics are detected during a second phase of epitaxial growth.
